# EUROPÄISCHE PATENTANMELDUNG

(11) **EP 4 141 491 A1**
(43) Veröffentlichungstag der Anmeldung: **01.03.2023**
(21) Anmeldenummer: 22186670.0
(22) Anmeldetag: 25.07.2022
(51) Int. Cl.: G01V 3/10, H03K 17/95

(54) **INDUKTIVER NÄHERUNGSSCHALTER UND VERFAHREN ZUM ERFASSEN VON GEGENSTÄNDEN**

(30) Priorität: 24.08.2021 DE 102021121886
(71) Anmelder: Turck Holding GmbH, 58553 Halver (DE)
(72) Erfinder: Ehls, Stefan, 58095 Hagen (DE); Müller, Jens, 08340 Schwarzenberg (DE)
(74) Vertreter: DTS Patent- und Rechtsanwälte Schnekenbühl und Partner mbB

(57) **Zusammenfassung**

Die vorliegende Erfindung betrifft einen induktiven Näherungsschalter mit einem Generator und/oder Oszillator, der eine ein magnetisches Wechselfeld erzeugende Sendespule speist, und der durch einen in das Wechselfeld eindringenden Gegenstand in seinem Schwingungszustand beeinflussbar ist,
- und mit einer Auswerteschaltung zur Gewinnung eines Schaltsignals aus der Änderung des Schwingungszustandes,
- wobei im Wechselfeld der Sendespule zwei Sensorspulen in unmittelbarer Differenzschaltung zur Erfassung der Differenz der in den beiden Sensorspulen induzierten Spannungen angeordnet sind,
- wobei die Sensorspulen durch ihre räumliche Lage zueinander und durch die jeweiligen Windungszahlen derart ausgebildet sind, dass die

Differenzwechselspannung beim gewünschten Ansprechabstand zu Null wird, wobei die Sendespule und die beiden Sensorspulen als Leiterplattenspulen ausgebildet sind, insbesondere als gedruckte Leiterplattenspulen, deren jeweiligen Windungen in einer für die jeweilige Leiterplatte gemeinsamen Ebene liegen, wobei jede der Spulen eine Hauptwicklung mit einer Hauptwicklungsrichtung aufweist und die beiden Sensorspulen zueinander gegenläufige Hauptwicklungen aufweisen, und wobei mindestens eine der Spulen eine zur eigenen Hauptwicklung gegenläufige Kompensationswicklung mit mindestens einer Windung aufweist, die radial außen von der Hauptwicklung angeordnet ist. Weiterhin umfasst die Erfindung ein Verfahren zur Erfassung von metallischen Körpern mit einem induktiven Näherungsschalten.

## Beschreibung

Die vorliegende Erfindung betrifft einen Näherungsschaltern nach dem Oberbegriff des Anspruchs 1 und ein Erfassungsverfahren für metallische Elemente nach dem Oberbegriff des Anspruchs 11.

Im Stand der Technik sind induktive Näherungsschalter bekannt, so beschreibt beispielsweise die DE 44 29 314 B4 einen solchen Näherungsschalter, bei dem ein magnetisches Wechselfeld in einer Spule erzeugt wird, so dass ein eindringender metallischer Gegenstand den Schwingungszustand beeinflusst. Die erfasste Änderung des Schwingungszustandes wird mit einer Schaltung ausgewertet, wobei im Wechselfeld zwei Sensorspulen in unmittelbarer Differenzschaltung zur Erfassung der induzierten Spannungen angeordnet sind. Die Differenzspannung der Sensorspulen wird dabei im Ansprechabstand zu Null. Bei der Lösung nach DE 44 29 314 B4 sind die gewickelten Spulen in drei Ebenen beziehungsweise in drei Korridoren angeordnet. Nachteilig an dieser Lösung ist, dass bei den gewickelten Spulen eine Neigung zur Alterung besteht, so dass der Schaltabstand im Laufe der Zeit driftet. Insbesondere ist der erreichbare maximale Schaltabstand mit gewickelten Spulen stark begrenzt.

Daher wird bereits in der DE 10 2006 053 023 A1 ein verbesserter induktiver Näherungsschalter mit einer ein magnetisches Wechselfeld erzeugenden planaren Sendespulenanordnung vorgeschlagen, die eine Sendespule und eine diese koaxial umgebende Kompensationsspule aufweist. Weiterhin ist eine Empfangsspule vorgesehen, wobei die Sendespule und die gemeinsame Kompensationsspule mit Wechselströmen entgegengesetzter Phase gespeist werden, und die Sendespule gegensinnig zur Kompensationsspule geschaltet ist und eine größere Windungszahl aufweist. Durch die gemeinsame Kompensationsspule und von ihr erzeugte äußere Feld und dessen Feldlinien, kommt es zu einer Kompensation der Feldlinien der Sendespule im Umgebungsbereich, so dass insgesamt der Fluss im Umgebungsbereich Null oder im Wesentlichen Null gebracht werden kann. Gemäß der DE 10 2006 053 023 A1 ist die Empfangsspule zwischen Sendespule und Kompensations-Sendespule angeordnet, und als ideale Lösung wird eine planare Anordnung vorgeschlagen, bei der Sende,-Empfangs- und Kompensationswindungen sich idealerweise auf einer Ebene befinden. Auf diese Weise werden allerdings von dem System nur Normschaltabstände erreicht, erweiterte Schaltabstände sind nicht realisierbar.

Es ist die Aufgabe der vorliegenden Erfindung eine verbesserte Spulenanordnung vorzuschlagen, bei der erweiterte Schaltabstände realisierbar sind.

Diese Aufgabe wird erfindungsgemäß gelöst durch einen induktiven Näherungsschalter nach den Merkmalen des Anspruchs 1 und einem Verfahren nach den Merkmalen des Anspruches 11. Vorteilhafte Ausgestaltungen sind in den jeweiligen, zugehörigen Unteransprüchen angegeben.

Danach wird die Aufgabe gelöst durch einen induktiver Näherungsschalter mit einem Generator und/oder Oszillator, der eine ein magnetisches Wechselfeld erzeugende Sendespule speist, und der durch einen in das Wechselfeld eindringenden metallischen Gegenstand in seinem Schwingungszustand beeinflussbar ist und mit einer Auswerteschaltung zur Gewinnung eines Schaltsignals aus der Änderung des Schwingungszustandes. Das Wechselfeld kann durch eine analoge oder digitale Schaltung erzeugt werden..

Im Wechselfeld der Sendespule sind zwei Sensorspulen in unmittelbarer Differenzschaltung zur Erfassung der Differenz der in den beiden Sensorspulen induzierten Spannungen angeordnet, wobei die Sensorspulen durch ihre räumliche Lage zueinander und durch die jeweiligen Windungszahlen derart ausgebildet sind, dass die Differenzwechselspannung beim gewünschten Ansprechabstand zu Null wird. Die drei Spulen sind idealerweise axial voneinander beabstandet.

Hierbei ist bei einer Ausführungsform die Differenzwechselspannung an den Eingang des Verstärkers geführt und ist derart, dass bei einem Nulldurchgang der Differenzwechselspannung (UD) der Oszillator seinen Schwingungszustand ändert, insbesondere sprunghaft ändert. Der Oszillator arbeitet hierbei in einem definierten Frequenzbereich. Bei dieser Ausführungsform kann ergänzend ein Generator vorgesehen werden, der den Oszillator in dessen Resonanzfrequenz anregt, ein Verstärker kann in dieser Variante entfallen, so dass die Differenzwechselspannung an den Eingang des Generators geführt ist.

Bei einer alternativen Ausführungsform ist der Verstärker ebenfalls durch einen Generator ersetzt, wobei die Sendespule in einer beliebigen Frequenz angeregt werden kann, da kein in Reihe zur Sendespule angeordneter Kondensator vorgesehen ist. Die an den Sensorspulen anliegende Spannungsamplitude wird in analoger Wiese mit einem Spannungsmesser ausgewertet.

Hierbei sind aber insgesamt die Sendespule und die beiden Sensorspulen als Leiterplattenspulen ausgebildet, insbesondere als gedruckte Leiterplattenspulen, deren jeweiligen Windungen in einer für die jeweiligen Leiterplatte gemeinsame Ebene liegen, wobei jede der Spulen eine Hauptwicklung mit einer Hauptwicklungsrichtung aufweist und die beiden Sensorspulen zueinander gegenläufige Hauptwickelrichtungen ihrer Hauptwicklungen aufweisen, und wobei mindestens eine der Spulen eine zur eigenen Hauptwicklung gegenläufige Kompensationswicklung mit mindestens einer Windung aufweist, die radial außen von der Hauptwicklung und auf der selben Ebene angeordnet ist. Die vorgenannten und voneinander axial beabstandeten Ebenen der Spulen, sind nicht im mathematischen Sinne als Ebene zu verstehen, sondern beschreiben einen engen Korridor beziehungsweise zueinander parallele oder im Wesentlichen parallele Korridore.

Bei einer verbesserten Ausführungsform des induktiven Näherungsschalters ist mindestens die Sendespule oder die beiden Sensorspulen als Gruppe von parallelen Spulen ausgebildet. Diese sind auf parallelen Ebenen angeordnet, wobei jede einzelne Ebene von einem Trägerkörper oder Platine gebildet wird. Dabei beträgt vorteilhafterweise die Anzahl der Ebenen der Sendespulen mindestens der Anzahl der Ebenen der Sensorspulen, idealerweise beträgt die Anzahl mindestens das 1,5-fache.

Bei einer üblichen Ausführungsform werden für die Gruppe von einzelnen Sendespulen vier bis sechs Ebenen vorgesehen, die jeweils eine Kompensationswicklung oder -windung in derselben Ebene bzw. demselben Korridor aufweisen. Die Gruppen der einzelnen Sensorspulen belegen bis zu vier Ebenen, wobei jede einzelne Sensorspule ein bis zwei Kompensationswicklungen oder - windungen aufweist. Insgesamt sind bei einer vorteilhaften Ausgestaltung somit 8 bis 10 Ebenen mit einzelnen, gedruckten Spulen vorzusehen.

Nachfolgend wird weiter von "Spulen" gesprochen, wobei hierunter immer auch eine Gruppe von mindestens zwei einzelnen Spulen auf zwei Ebenen verstanden werden soll.

In dem Ausführungsbeispiel, dass jede Spule mindestens eine Kompensationswicklung aufweist, sind die Effekte und Vorteile wie folgt:
Die gegenläufige, koaxial gewickelte Kompensationswicklung zur vorderen Sensorspule sorgt für eine Reduzierung des Schaltabstandes beim Einbau des Sensors in eine Metallumgebung, weil diese nicht als Erfassungsgegenstand erkannt wird. Ohne eine Kompensationswindung würde der Sensor das Umgebungsmetall erkennen und ein falschpositives Signal liefern.

Die gegenläufig gewickelte Kompensationswindung der Sendespule in der Mittellage, erfasst im Wesentlichen ein umgebenes Gewinderohr und reduziert eine nachteilige Schaltabstandsänderung, wenn das Spulensystems in das Gewinderohr im Produktionsprozess eingeführt ist. Weiterhin können auf diese Weise auch etwaige Verformungen oder Verschiebungen des Gewinderohres teilweise kompensiert werden.

Wird die hintere Sensorspule um mindestens eine Kompensationswindung erweitert, wird hierdurch im Wesentlichen die Oszillatoreigenschaften verbessert, so dass unerwünschte Phasenverschiebungen zwischen Sende- und Empfangsspannungen korrigierbar sind. Auf diese Weise können sehr hohe Schaltabstände erreicht werden.

Bei einer verbesserten Ausführungsform ist vorgesehen, dass mindestens eine Ebene von mindestens einer Gruppe von Spulen dadurch gebildet ist, dass auf eine untere Ebene oder einzelne Spule mindestens eine nicht leitende Trennschicht in Form beispielsweise eines nicht leitenden Lacks, Harzes oder dergleichen aufgebracht ist, auf welcher die darüberliegende, obere Ebene beziehungsweise obere Spule aufgebracht ist, wobei die Spule insbesondere durch ein Druck- oder Ätzverfahren aufgebracht wurde. Vorteilhafterweise ist auf die oberste Spule einer derart geschichteten Gruppe ein schützendes Coating, Lack, Harz oder dergleichen aufgebracht. Bei einer vorteilhaften Ausführungsform ist auch das Coating mit einem Verfahren aufgedruckt worden.

Dabei ist vorteilhafterweise bei der Sendespule und den beiden Sensorspulen jeweils nur eine zur eigenen Hauptwicklung gegenläufige Kompensationswicklung mit mindestens einer Windung vorgesehen, die radial außen von der jeweiligen Hauptwicklung angeordnet sind. Zudem sind vorteilhafterweise die die Windungen der Hauptwicklungen der Sendespule und der beiden Sensorspulen zueinander parallel ausgerichtet, wie auch die jeweilige Kompensationsspule.

Bei einer vorteilhaften Ausführungsform, insbesondere bei der Verwendung als bündigen, induktiver Näherungsschalter, ist die Sendespule zwischen den beiden Sensorspulen angeordnet, insbesondere mit identischem Abstand zwischen den Sensorspulen angeordnet.

Bei einer Ausführungsform, die insbesondere für nichtbündige, induktive Näherungsschalter von Vorteil ist, ist die Sendespule hinter den Sensorspulen angeordnet, wobei "hinter" aus Blickrichtung der Erfassungsseite meint.

Bei einer weiter verbesserten Ausführungsform wird ein spezielles Verhältnis der Windungsabstände von Hauptwicklung und Kompensationswicklung eingehalten. Hierbei haben die Windungen der Hauptwicklungen der einzelnen Spulen, also auf einer Ebene, untereinander einen ersten Wicklungsabstand. Der Abstand der äußersten Windung der Hauptwicklung zur innersten bzw. der einen Windung der Kompensationswicklung ist deutlich größer als der Wicklungsabstand der Hauptwicklung. Dieser Abstand zwischen Hauptwicklung und Kompensationswicklung ist insbesondere mindestens das Zweifache und maximal das zwanzigfache des Wicklungsabstandes der Hauptwicklung.

Weiterhin beträgt der (innere) Wicklungsabstand zwischen den einzelnen Windungen der Kompensationswicklung maximal das fünffache des Windungsabstandes der Hauptwicklung.

Hierbei sind die drei Spulen oder Gruppen von Spulen axial voneinander beabstandet, wobei der Abstand der Sensorspule von der Sendespule 20- bis 100-mal kleiner ist, als der Spulendurchmesser. Innerhalb einer Gruppe von Einzelspulen ist der Abstand kleiner als 3 mm, idealerweise kleiner als 1 mm.

Bei einer vorteilhaften Ausführungsform haben die beiden Sensorspulen von der zentral angeordneten Sendespule denselben oder den im Wesentlichen selben Abstand. Dies hat den Vorteil, dass die beiden Sensorspulen im Wesentlichen identisch sind und auf diese Weise der beste Kompromiss zwischen Bündigkeit und Reichweite des Sensors erlangt wird. Bei einer Sonderausführungen mit unterschiedlichem Abstand der beiden Sensorspulen von der zentral angeordneten Sendespule, muss das Windungsverhältnisse der ersten Sensorspulen zur zweiten Sensorspule entsprechend angepasst werden.

Bei einer weiter vorteilhaften Ausführungsform ist vorgesehen, dass mindestens eine Kompensationswicklung auf einer Ebene genau eine Windung aufweist, und wobei die eine Windung oder Wicklung um mindestens 300 Winkelgrad umschließt, idealerweise mindestens um 340 Winkelgrad umschließt. Vorteilhafterweise haben alle Kompensationswicklungen auf der jeweiligen Ebene genau eine Windung.

Energetisch besonders vorteilhaft ist die Bildung eines selbstanregenden Systems. Hierzu sieht eine besonders vorteilhafte Ausführungsform vor, dass nur ein Oszillator ohne (aktiven) Generator vorgesehen ist. Hierbei wird über die als Induktivität wirkende Sendespule und einen parallelen Kondensator ein LC-Resonator gebildet. Dieser ist in Reihe mit dem Verstärker und den Sensorspulen bzw. den zugehörigen Kompensationsspulen zu einem LC Oszillator verschaltet, wobei ein Wechselfeld erzeugt werden kann. Dieses Wechselfeld ist insbesondere ein in Resonanzfrequenz schwingendes, selbstanregendes Wechselfeld.

Von der Erfindung ist weiterhin auch ein Verfahren zur Erfassung eines metallischen Gegenstandes unter Verwendung eines induktiven Näherungsschalten umfasst, der nach einem der vorherigen Ausführungsformen oder eine Kombination hiervon ausgebildet ist.

Weitere Einzelheiten und Vorteile der Erfindung sollen nun anhand eines in den Zeichnungen dargestellten Ausführungsbeispiels näher erläutert werden.

Es zeigen:
- Fig. 1: eine schematische Schnittdarstellung des Näherungssensors mit zugehöriger, stark vereinfachter Verschaltung,
- Fig. 2a, b: zwei Verschaltungsvarianten des Näherungssensors,
- Fig. 3: eine schematische, perspektivische Darstellung des Näherungssensor und die Windungsanordung von drei Spulen,
- Fig. 4: eine zur Figur 1 alternative Ausführungsform des Näherungsschalters und
- Fig. 5: eine weitere Verschaltungsvariante des Näherungsschalters.

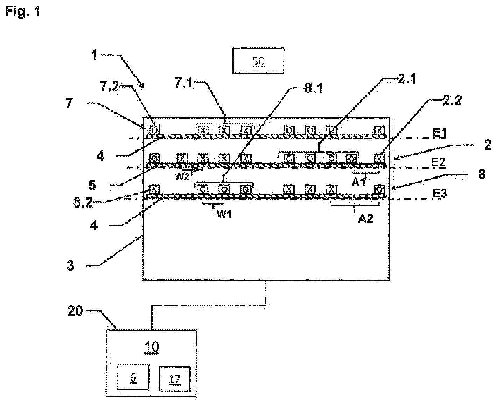

Fig. 1 zeigt einen schematischen Aufbau des Näherungsschalters 1, der ein schematisch angedeutetes Gehäuse 3 und in dem Gehäuse 3 drei Trägerplatten 4, 5 aufweist. Diese sind zueinander parallel auf den drei Ebenen E1, E2 und E3 angeordnet. Auf jeder der oberen Trägerplatte 4 und der unteren Trägerplatte 4 ist jeweils eine Sensorspule 7, 8 angeordnet, wobei die obere Sensorspule 7 auf der Erfassungsseite angeordnet ist, die durch den zu erfassenden Gegenstand 50 skizziert ist. Der induktive Näherungssensor 1 ist mit einer Verschaltung 20 auf, die gesondert eingehaust oder integraler Bestandteil des Näherungssensors sein kann. Die Verschaltung 20 umfasst insbesondere einen Kondensators 17, einen Verstärker 10 und eine Spannungsmesseinheit 6, zur Erfassung der Spannungsänderung der Sensorspulen 7, 8, wie nachstehend ausgeführt.

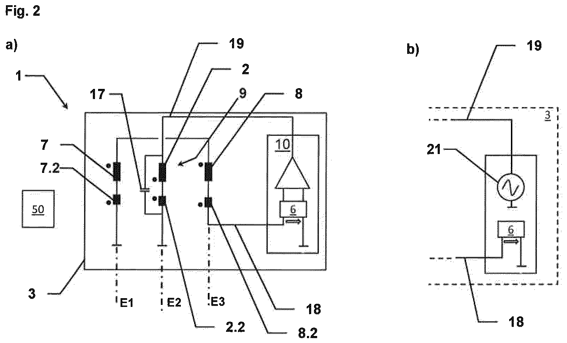

In dem gezeigten Beispiel der Figur 1 und dem der Figur 2a), ist die als Induktivität wirkende Sendespule 2 und der parallele Kondensator 17 als LC-Resonator ausgebildet. Dieser ist in Reihe mit dem Verstärker 10 und einer oder mehreren Sensorspulen 2 bzw. einer oder mehreren zugehörigen Kompensationsspulen 2.2 zu einem LC Oszillator verschaltet, wodurch ein in Resonanzfrequenz schwingendes, selbstanregendes Wechselfeld erzeugt wird.

Die beiden Sensorspulen 7, 8 sind identisch, aber gegenläufig gewickelt und weisen am äußeren Rand eine, aus einer einzelnen Windung bestehende Kompensationswindung 7.2, 8.2 auf. Hierbei ist mit dem "X" und dem "O" die jeweilige Flussrichtung des Stroms angedeutet. Diese Kompensationswindung 7.2, 8.2 um schließt die jeweilige Hauptwicklung 7.1, 8.1 des Sensorspulen 7, 8.

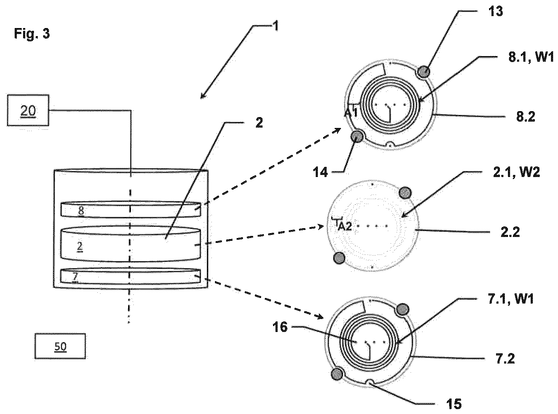

In analoger Weise wird die Hauptwicklung 2.1 der Sendespule 2 auch von einer Kompensationswicklung 2.2 umschlungen, die einen Abstand A2 von der äußersten Windung der zugehörigen Hauptwicklung 2.1 hat. Diese beträgt vorliegend das 4-fache des Wicklungsabstandes W2 der Hauptwicklung 2.1, wie insbesondere in der Figur 3 im Detail zu erkennen ist.

Hierdurch werden die vorteilhaften Effekte erreicht, dass der Schaltabstandes beim Einbau des Sensors in einer Metallumgebung verbessert wird, Kompensation von etwaigen Verformungen oder Verschiebungen des Gewinderohres und schließlich wird durch die hintere Kompensationswindung 8.2 der hinteren Sensorspule 8 die Oszillatoreigenschaften verbessert, so dass unerwünschte Phasenverschiebungen zwischen Sende- und Empfangsspannungen korrigierbar sind.

Wie in der Figur 2a) zu sehen und vorstehend ausgeführt, wird der Näherungsschalter 1 von einem Oszillator 9 angeregt, der über eine Sendespule 2, 2.2, die als Induktivität zusammen mit einem Kondensator 17 einen LC-Resonator bildet und über die Leitung 19 in Reihe mit einem Verstärker 10 und den Sensorspulen 7, 7.2, 8, 8.2 zu einem LC Oszillator verschaltet ist und ein Wechselfeld erzeugt. Die beiden gegenläufig gewickelten Sensorspulen 7, 8 sind in unmittelbarer Differenzschaltung angeordnet. Die sich ergebende Differenzwechselspannung der beiden Sensorspulen 7, 8 wird über die Leitung 18 an den Eingang des Verstärkers 10 geliefert und von dem Spannungsmesser 6 erfasst. Die Sensorspulen 7, 8 sind durch ihre räumliche Lage auf den beiden zueinander parallelen Ebenen E1, E3 und die jeweiligen Windungszahlen derart ausgebildet, dass die Differenzwechselspannung UD bei Annäherung eines Auslösers auf den gewünschten Ansprechabstand zu Null wird, wobei die Änderungen der Schwingungszustände in nicht dargestellter Weise erfasst und zu einem Schaltsignal gewandelt wird. Derartige Schaltungen sind dem Fachmann grundsätzlich bekannt, beispielsweise aus der DE 44 29 314 B4 oder der DE 40 31 252 C1. Auch die Auslegung derartiger Schaltungen für unterschiedliche Betriebsarten, zur materialabhängigen Erfassung (metallisch, nicht-metallisch) unterschiedlicher Gegenstände 50 sind dem Fachmann beispielsweise aus der vorgenannten DE 44 29 314 B4 bekannt.

In einer weiteren Ausführungsform (Fig. 2b) wird der Verstärker 10 durch einen Generator 21 ersetzt und die an den Sensorspulen 7,8 anliegende Spannungsamplitude wird mittels des Spannungsmessers 6 ausgewertet.

Hierzu ist ein über die Leitung 19 verbundener Generator 21 vorgesehen und der den Resonator aus mindestens einer Sendespule 2 und zugehörigen Kompensationsspulen 2.2 sowie dem Kondensator 17 in dessen Resonanzfrequenz anregt. Der Verstärker 10 kann, wie vorstehend ausgeführt, bei dieser Ausführungsform entfallen.

In den Figuren 2a, 2b sind weiterhin die Kompensationswicklungen 2.2, 7.2, 8.2 auf allen drei Ebenen angedeutet, insbesondere auch, dass der schwingende Kondensator 17 die Zu- und Ableitung über die Kompensationswicklung 2.2 hinweg einschließt.

In der Figur 3 sind die einzelnen Spulenplatten oder -platinen 2, 7, 8 im Detail dargestellt. Die äußeren Sensorspulen 7, 8, sind identisch aufgebaut, werden aber gegensinnig durchflossen. Die Hauptwicklung 7.1, 8.1 der Sensorspulen 7, 8 haben einen nicht eingezeichneten Wicklungsabstand W1. Der Abstand A1 zu Kompensationswicklung 7.2, 8.2 beträgt beispielsweise das 10-fache des Wicklungsabstandes W1.

Die in Mittellage befindliche Sendespule 2 weist einen zu W1 etwas größeren Wicklungsabstand W2 der Hauptspule 2.1 auf, wodurch der beste Kompromiss zwischen Bündigkeit und Reichweite des bündigen Sensors erreicht wird.

Der Abstand A2 zwischen der zentralen Hauptwicklung 2.1 und der Kompensationswicklung 2.1 beträgt beispielsweise das fünffache des Wicklungsabstandes W2 der Hauptwicklung 2.1.

Weiterhin sind die Löt- und Anschlusspunkte 15, 16 zu erkennen und die äußeren Befestigungen 13, 14. Hierbei ist zu erkennen, dass zur kompakten Konstruktion und maximal radial äußeren Führung der Kompensationswicklungen 7.2, 8.2, die in Außenlage befindlichen Löt- und Kontaktpunkte 15, 16 und auch die am Rand befindlichen Befestigungen, von der Kompensationswicklung 7.2, 8.2 auf einem Winkelbereich umschlungen werden und die Kompensationswicklung hierzu nach innen einen Teilbogenverlauf aufweist.

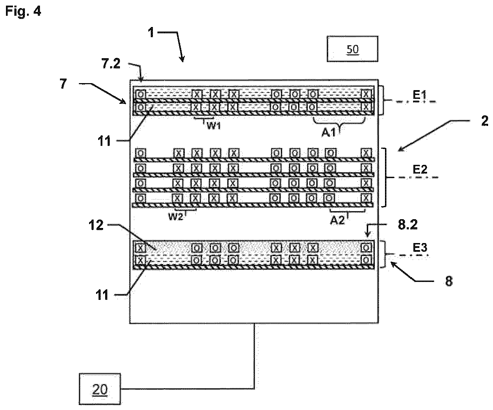

Figur 4 zeigt den Näherungsschalter gemäß der Figur 3 in einer Schnittdarstellung. Zu die Gruppen aus je zwei Sensorspulen 7, 8 sind mit einem Coating 11, 12 überdeckt, wie mit dem gestrichelten Feld angedeutet. Die Besonderheit der hinteren Gruppe der Sensorspule 8 besteht darin, dass auf dem Coating 11 der unteren, tragenden Einzelspule, direkt eine obere (einzelne) Sensorspule aufgedruckt wurden, die mit einem weiteren Coating 12 überdeckt ist, so dass die beiden Coating 11, 12 ineinander übergehen. Die obere, einzelne Sensorspule 8 weist somit keinen eigenen Spulenträger oder Leiterplatte auf. Der erforderliche Kontakt zur unteren Spule ist über eine nichtdargestellte Auslassung im unteren Coating 11 realisiert.

Im Regelfall wird man die beiden Sensorspulen 7, 8 identisch ausbilden, also gemäß der oberen oder unteren Variante. Die dazwischen angeordnete Gruppe der Sendespule 2 zentriert sich um die Ebene 2 und weist die vorgenannten Wicklungsabstände W1 und den Abstand A2 zu Hauptspule 2.1 auf.

Es ist unmittelbar ersichtlich, dass der Fachmann die Merkmale zum vertikalen Spulenaufbau des Ausführungsbeispiels nach Figur 4 bedarfsweise bei den andere Ausführungsvarianten vorsehen wird.

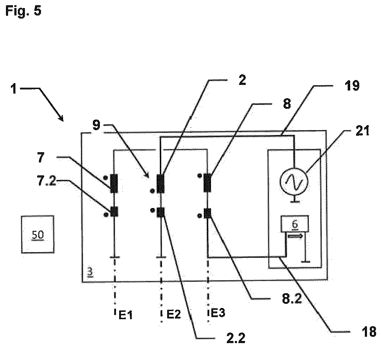

In einer weiteren Ausführungsform (Fig. 5) ist ein über die Leitung 19 verbundener Generator 21 vorgesehen, der die mindestens eine Sendespule 2 und zugehörige Kompensationsspulen 2.2 in einer beliebigen Frequenz anregen kann, da der in Reihe geschaltete Kondensator 17, wie beispielsweise in der Figur 2b dargestellt, nicht vorgesehen ist.

### Bezugszeichenliste

1 Näherungsschalter
2 Sendespule
   2.1 Hauptwicklung
   2.2 Kompensationswicklung
3 Gehäuse
4 Spulenträger
5 Spulenträger
6 Spannungsmesser
7 Sensorspule, erste
   7.1 Hauptwicklung
   7.2 Kompensationswicklung
8 Sensorspule, zweite
   8.1 Hauptwicklung
   8.2 Kompensationswicklung
9 Oszillator
10 Verstärker
11 Coating, erstes
12 Coating, zweites
13 Befestigung, erste
14 Befestigung, zweite
15 Löt- und Anschlusspunkt, äußerer
16 Löt- und Anschlusspunkt, innerer
17 Kondensator
18 Leitung
19 Leitung
20 Verschaltung
21 Generator
50 Gegenstand
A1 Abstand
A2 Abstand
W1 Windungsabstand
W2 Windungsabstand

## Patentansprüche

1. Induktiver Näherungsschalter (1) mit einem Generator (21) und/oder Oszillator (9), der eine ein magnetisches Wechselfeld erzeugende Sendespule (2) speist, und der durch einen in das Wechselfeld eindringenden metallischen Auslöser (50) in seinem Schwingungszustand beeinflussbar ist,
- und mit einer Auswerteschaltung zur Gewinnung eines Schaltsignals aus der Änderung des Schwingungszustandes,
- wobei im Wechselfeld der Sendespule (2) zwei Sensorspulen (7, 8) in unmittelbarer Differenzschaltung zur Erfassung der Differenz der in den beiden Sensorspulen (7, 8) induzierten Spannungen angeordnet sind,
- wobei die Sensorspulen (7, 8) durch ihre räumliche Lage zueinander und durch die jeweiligen Windungszahlen derart ausgebildet sind, dass die Differenzwechselspannung beim gewünschten Ansprechabstand zu Null wird, und wobei die Differenzwechselspannung an den Eingang eines Verstärkers (10) oder eines Generators (21) geführt ist,
,und wobei die drei Spulen axial voneinander beabstandet sind,
**dadurch gekennzeichnet, dass**
die Sendespule (2) und die beiden Sensorspulen (7, 8) als Leiterplattenspulen ausgebildet sind, insbesondere als gedruckte Leiterplattenspulen, deren jeweiligen Windungen in einer für die jeweilige Leiterplatte gemeinsamen Ebene (E1, E2, E3) liegen, wobei jede der Spulen eine Hauptwicklung (2.1, 7.1, 8.1) mit einer Hauptwicklungsrichtung aufweist und die beiden Sensorspulen (7, 8) zueinander gegenläufige Hauptwickelrichtungen ihrer Hauptwicklungen (7.1, 8.1) aufweisen, und wobei mindestens eine der Spulen eine zur eigenen Hauptwicklung (2.1, 7.1, 8.1) gegenläufige Kompensationswicklung (2.2, 7.2, 8.2) mit mindestens einer Windung aufweist, die radial außen von der Hauptwicklung (2.1, 7.1, 8.1) angeordnet ist.

2. Induktiver Näherungsschalter (1) nach Anspruch 1, **dadurch gekennzeichnet, dass** mindestens Sendespule (2), eine oder die beiden Sensorspulen (7, 8) als Gruppe von parallelen Spulen ausgebildet sind, die auf parallelen Ebenen angeordnet sind, wobei insbesondere die Anzahl der Ebenen der Sendespulen (2) mindestens der Anzahl der Sensorspulen (7, 8) beträgt, idealerweise das 1,5-fache.

3. Induktiver Näherungsschalter (1) nach Anspruch 1 oder 2, **dadurch gekennzeichnet, dass** die Sendespule (2) und die beiden Sensorspulen (7, 8) jeweils eine zur eigenen Hauptwicklung gegenläufige Kompensationswicklung (2.2, 7.2, 8.2) mit mindestens einer Windung aufweisen, die radial außen von der jeweiligen Hauptwicklung (2.1, 7.1, 8.1) angeordnet sind.

4. Induktiver Näherungsschalter (1) nach Anspruch 1 oder 2, **dadurch gekennzeichnet, dass** die Windungen der Hauptwicklungen (2.1, 7.1, 8.1) der Sendespule (2) und der beiden Sensorspulen (7, 8) zueinander parallel ausgerichtet sind.

5. Induktiver Näherungsschalter (1) nach einem der vorherigen Ansprüche, **dadurch gekennzeichnet, dass** entweder die Sendespule (2)
- zwischen den beiden Sensorspulen (7, 8) oder
- hinter den beiden Sensorspulen (7, 8) angeordnet ist.

6. Induktiver Näherungsschalter (1) nach einem der vorherigen Ansprüche, **dadurch gekennzeichnet, dass** die Windungen der Hauptwicklungen (2.1, 7.1, 8.1) untereinander einen ersten Wicklungsabstand (W1; W2) haben und der Abstand (A1, A2) der äußersten Windung der Hauptwicklung (2.1, 7.1, 8.1) zur innersten Windung der Kompensationswicklung (2.2, 7.2, 8.2) größer als der Wicklungsabstand (W1) ist, insbesondere mindestens das Zweifache und maximal das zwanzigfache des Wicklungsabstandes (W1, W2) beträgt.

7. Induktiver Näherungsschalter (1) nach einem der vorherigen Ansprüche, **dadurch gekennzeichnet, dass** die beiden Sensorspulen (7, 8) von der zentral angeordneten Sendespule (2) denselben oder den im Wesentlichen selben Abstand haben.

8. Induktiver Näherungsschalter (1) nach einem der vorherigen Ansprüche, **dadurch gekennzeichnet, dass** mindestens eine Kompensationswicklung genau eine Windung aufweist, und wobei die Windung die zentrale Hauptwicklung um mindestens 300 Winkelgrad umschließt, idealerweise mindestens um 340 Winkelgrad umschließt.

9. Induktiver Näherungsschalter (1) nach Anspruch 8, **dadurch gekennzeichnet, dass** alle Kompensationswicklungen (2.2, 7.2, 8.2) genau eine Windung pro Ebene aufweisen.

10. Induktiver Näherungsschalter (1) nach einem der vorherigen Ansprüche, **dadurch gekennzeichnet, dass** nur ein Oszillator (9) ohne Generator vorgesehen ist, wobei über die als Induktivität wirkende Sendespule (2, 2.2) und einen Kondensator (17) ein LC-Resonator gebildet wird, der in Reihe mit dem Verstärker (10) und den Sensorspulen (7, 7.2, 8 , 8.2) zu einem LC Oszillator verschaltet ist und mittels welchem ein Wechselfeld erzeugt werden kann, insbesondere als ein in Resonanzfrequenz schwingendes, selbstanregende Wechselfeld.

11. Verfahren zur Erfassung eines metallischen Gegenstandes, **dadurch gekennzeichnet, dass** ein induktiver Näherungsschalten (1) nach einem der vorherigen Ansprüche 1 bis 10 verwendet wird.
